Europäisches Patentamt

European Patent Office

Office européen des brevets

(11) Publication number: **0 120 830 B1**

## EUROPEAN PATENT SPECIFICATION

(45) Date of publication of patent specification: **15.07.92**

(51) Int. Cl.⁵: **H01L 21/322**, H01L 21/314, H01L 21/205

(21) Application number: **84870021.7**

(22) Date of filing: **13.02.84**

(54) Semiconductor substrate materials having enhanced gettering ability.

(30) Priority: **14.02.83 US 466249**
**04.04.83 US 481597**

(43) Date of publication of application:
**03.10.84 Bulletin 84/40**

(45) Publication of the grant of the patent:
**15.07.92 Bulletin 92/29**

(84) Designated Contracting States:
**DE FR GB IT**

(56) References cited:
**FR-A- 2 346 856**

**EXTENDED ABSTRACTS, vol. 81-1, May 1981, pages 800-802, abstracts 320, Pennington, N.J., US; M.C. CHEN et al.: "Effect of poly-Si gettering scheme on the quality of Si epitaxial film"**

**THIN SOLID FILMS, vol. 75, no. 2, January 1981, pages 125-131, Elsevier Sequoia, Lausanne, CH; D. IOSIV et al.: "Polysilicon passivation of semiconductor devices"**

(73) Proprietor: **MEMC Electronic Materials, Inc.**
**501 Pearl Drive (O'Fallon) P.O. Box 8**
**St. Peters, Missouri 63376(US)**

(72) Inventor: **Hill, Dale Eugene**
**940 Wood Avenue**
**Kirkwood Missouri 63122(US)**

(74) Representative: **Thomson, Roger Bruce et al**
**W.P. THOMPSON & CO. Eastcheap House**
**Central Approach**
**Letchworth Hertfordshire SG6 3DS(GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

SOLID-STATE TECHNOLOGY, vol. 24, no. 7, July 1981, pages 44-51, Port Washington, N.Y., US; J.R. MONKOWSKI: "Gettering processes for defect control"

SILICON PROCESSING FOR THE VLSI ERA. Volume 1: p. 63-65

HANDBOOK OF THIN FILM TECHNOLOGY

VLSI FABRICATION PRINCIPLES; SILICON AND GALLIUM ARSENIDE; Sorab K. Ghandhi

Part 2b - Deposited Dielectrics for VLSI

Silicon Processing for the VLSI ERA; Stanley Wolf

**Description**

This invention relates to the manufacture of electronic devices such as integrated circuits. Particularly, this invention relates to improved semiconductor substrate materials, such as silicon wafers, used in the manufacture of integrated circuit devices. Specifically, this invention is directed to semiconductor substrate materials having enhanced ability for the gettering of deleterious impurities, contaminants and defects away from the region of device formation, during device manufacture.

In the manufacture of integrated circuit devices on silicon wafers, the presence of and introduction of defects, contaminants and impurities on and near the device formation surface of the wafer creates excessive current leakages which greatly affect the yield of usable devices obtained. The art has recognized that to some extent the deleterious defects, contaminants and impurities can be relocated to non-harmful regions in the substrate material away from the device formation region. The methods and processes for diffusing and trapping the defects, contaminants and impurities away from the active device region both prior to and during device formation are termed gettering in the electronics industry and art.

Several techniques and processes for gettering in semiconductor materials to improve device yields have been disclosed in the art. Known gettering techniques and processes for semiconductor materials can be generally classified as being based on external or internal means.

External gettering involves modifying the backside surface of the wafer to provide sites to which the defects, contaminants and impurities are attracted. A present commercially used external gettering technique is to impart mechanical damage to the backside of the wafer. The mechanical damage is imparted to the backside of the wafer by scratching the surface or sanding or grinding with an abrasive means to alter the crystalline structure and produce imperfections which attract and trap defects, contaminants and impurities away from the active device region of the wafer. Although backside damaged wafers provide gettering, the damage to the wafer creates additional problems in fragility, handling and cleaning to remove particulates formed and the damaged area provides potential traps for holding fluids and materials employed in the device manufacturing process which can result in further wafer contamination. U.S. Patent 4,144,099 describes wafer gettering by employing backside mechanical damage.

Another example of external gettering is described in U.S. Patent 3,997,368 wherein a stressed layer of silicon nitride or aluminum oxide is formed on the backside of the wafer, which is then annealed to cause stacking fault nucleation sites to diffuse to the backside. Still another example is described in U.S. Patent 3,929,529 wherein a surface of the wafer is anodized to form a layer of porous silicon, the contaminants are diffused from the body of the wafer to the porous silicon and the porous silicon layer is then oxidized to silicon dioxide

U.S. Patent 4,053,335 (equivalent to FR-A-2346856) discloses a means of external gettering in semiconductor materials by providing a layer of polysilicon on the backside of the wafer. The grain boundaries of the polysilicon provide sites for the segregation of impurities from the substrate. As the polysilicon grain boundaries are not annealed out at high temperature, the gettering capabilities remain effective throughout high temperature processing used in device manufacture.

Other commonly employed external type gettering means utilize boron- or phosphorus-doped semiconductor materials, ion implantation, such as argon, or heavy diffusion of impurities, such as boron and phosphorus, into the substrate material. U.S. Patent 3,874,936 provides a description of the latter technique.

More recently, the gettering effect of oxygen contained in the substrate material has been reported in "Solid State Technology", July 1981, pages 55-61, and is referred to as internal gettering. Oxygen is present in Czochralski grown silicon as it is introduced into the crystal from the dissolution of the quartz crucible employed to hold the silicon melt during crystal pulling. The precipitation of oxygen contained in the substrate material can form useful sites for gettering deleterious defects, contaminants and impurities.

With any gettering means, the active region of the substrate material where the devices are formed must be free of gettering sites. Thus, a zone about 5-25 microns and preferably about 10-20 microns in depth from the device surface of the wafer which is denuded of gettering sites must be created to prevent device yield loss from defect interference. The oxygen concentration in a substrate material can be reduced near the surface through outward diffusion under the process thermal conditions employed in device manufacture.

With the rapidly advancing device manufacturing technology and particularly with respect to complex and lengthy processing steps and increased circuit density and total circuit size on a wafer, it has become apparent that improvements are needed in the gettering capabilities of substrates to cope with the increased requirements and provide effective gettering throughout the device processing steps in order to achieve an acceptable yield of good devices per wafer.

Typical objects of this invention are to provide:

1. a semiconductor substrate having improved gettering capabilities,

2. a semiconductor substrate which provides external gettering capabilities,

3. a semiconductor substrate exhibiting enhanced gettering capabilities throughout device processing cycles, and

4. a semiconductor substrate which exhibits reduced defect formation in the active device region and provides increased minority carrier lifetime.

Other objects, characteristics and advantages of this invention will become apparent to those skilled in the art from this disclosure and appended claims.

In accordance with this invention, an improved semiconductor substrate is provided which exhibits enhanced gettering capabilities throughout device manufacturing cycles, imparts improved minority carrier lifetime and reduces yield loss of devices made due to deleterious defects, contaminants and impurities. The enhanced gettering capabilities are imparted to the semiconductor wafer by applying a gettering layer to the backside of the wafer. The enhanced gettering capabilities of the semiconductor wafer are further improved when the layer of polysilicon on the backside of the wafer has oxygen added to it.

It has been found that the external polysilicon layer although reducing the depth of the oxygen denuded zone obtained in the wafer enhances the oxygen precipitation providing an unexpected increase in sites for gettering of impurities and an unexpected increase in minority carrier lifetime as a function of the temperatures employed in a particular device manufacturing process. The thickness of the polysilicon layer effectively controls the depth of the oxygen denuded zone formed and the degree of oxygen precipitated in the wafer. Thus, the thickness of the polysilicon layer provides a determinant for providing a sufficiently deep oxygen-denuded zone and increased oxygen precipitation for effective gettering, as a function of the temperatures employed in the device manufacturing processes, with the resultant increase in device yield.

The synergistic gettering effect provided by the polysilicon layer is achieved when device processing temperatures do not go beyond about 1025°C. or, at least, go beyond about 1025°C. only for a sufficient period of time until the desired denuded zone is depleted of oxygen. At processing temperatures greater than 1025°C., the oxygen in the wafer generally remains in solution and does not tend to precipitate.

Oxygen-doped polysilicon is referred to in the electronics industry as SIPOS (semi-insulating polycrystalline-silicon). Thermally deposited SIPOS has been used as passivation films on devices and has received considerable attention in the literature. An early article "Semi-Insulating Polycrystalline-Silicon (SIPOS) Films Applied To MOS Integrated Circuits" by H. Mochizuki et al in the supplement to Japanese Journal Of Applied Physics, Vol. 15, 1976, pages 41-48, discusses the use of SIPOS films for the surface passivation of integrated circuits. Another article discussing the two phases - silicon micro-crystals and silicon oxide - of SIPOS is "Crystallographic Study Of Semi-Insulating Polycrystalline Silicon (SIPOS) Doped With Oxygen Atoms", by M. Hamasaki et al is found in J. Appl. Phys., 49(7), July 1978, pages 3987-3992. An article "A Model Of SIPOS Deposition Based On Infrared Spectroscopic Analysis", by W. R. Knolle et al in J. Electrochem. Soc., Solid-State Science and Technology, October 1980, pages 2254-2259, discusses deposition of SIPOS at atmospheric and low pressures

SIPOS is deposited on semiconductor substrate materials, such as silicon wafers, by the well known chemical vapor deposition (CVD) technology, wherein the reactant in vapor form is thermally decomposed or is reduced using hydrogen or other known reducing agents. SIPOS is deposited by using a reactant in the form of a silicon-containing material, such as silane or a chlorinated silicon such as trichlorosilane, and an oxygen-containing material. The oxygen-containing material can be a non-metallic oxygen-containing complex such as oxides of nitrogen, carbon and hydrogen, and oxidizing agents such as a phosgene as well as oxygen itself. The oxygen content of the deposited SIPOS film can be regulated by controlling the ratios of the silicon and oxygen in the reactant gas.

A polysilicon (doped or undoped) layer on the wafer creates a strain resulting in a degree of bow or warpage in the wafer. The level of strain introduced is in part dependent upon the temperature at which the polysilicon layer is applied, the oxygen content of the layer, and the deposition pressure and rate. Suitable doped polysilicon layers for the purpose of this invention can be deposited onto the wafers at temperatures generally within the range of 600° to 800°C. Polysilicon deposition occurs at lower temperatures, but at about 600°C. the deposition is too slow to be economically practical. Deposition can also occur at higher temperatures, but at about 800°C. the grain size of the polysilicon tends to become too large for effective gettering or control problems can occur, particularly when using silane as a reactant. The effect of the level of oxygen doping of the polysilicon layer on the strain introduced and the resulting bow warpage varies with the deposition conditions employed. Temperatures in the range of about 680°C.-700°C. are found to introduce the least strain into the wafer. Bow and warpage of the wafer is also proportional to the polysilicon layer thickness.

In accordance with this invention, effective gettering is obtained utilizing various thicknesses of doped polysilicon layers on the backside of the substrate materials. Generally, the layer thickness can range broadly from 0.05 to 5.0 microns, preferably from 0.2 to 2.0 microns, and more specifically from 0.6 to 1.0 micron. The dopant concentration in the layer can also vary over a broad range while achieving gettering capability. Generally dopant concentrations can broadly range from 0.1 to 40 weight percent, preferably from 2 to 20 weight percent, and more specifically from 4 to 10 weight percent.

DESCRIPTION OF PREFERRED EMBODIMENTS

In the following Examples, a low pressure chemical vapor deposition (LPCVD) reactor of the type described in articles by M. L. Hitchman and J. Kane in the J. of Crystal Growth, 55,485 (1981) and by M. L. Hitchman, J. Kane and A. E. Widmer in Thin Solid Films, 59,23 (1979) is employed to deposit oxygen doped polysilicon layers. The wafer carrier employed is simply an elongated boat device having outwardly slanting transversely grooved sides and is open at the bottom for holding a plurality of wafers on edge and parallel to each other with about 4.76 mm. spacing between the wafers. The reactor is operated at 680°C. unless otherwise specified. The feed is silane and $N_2O$ and is introduced at the rates indicated. The reactor is operated at the indicated pressures by pulling a vacuum on the system using a 26.8 CFM pump.

Silicon wafers which have been lapped and chemically etched by conventional commercial technology are used. Polysilicon or SIPOS layers are deposited on both sides of the wafers in the reactor, although it is to be understood that deposition of doped polysilicon only on one side of the wafer is sufficient for purposes of this invention. The thickness of the doped polysilicon layers deposited on the wafers is controlled by regulating the deposition time in the reactor. Under the conditions employed using 7.62 cm. wafers, a 0.8 micron thick undoped polysilicon layer is deposited in 35 minutes and a 1.5 micron thick layer is deposited in 65 minutes, whereas a 0.8 micron thick SIPOS layer is deposited in 48 minutes and a 1.5 micron thick layer is deposited in 91 minutes. The wafers after removal from the furnace are further processed using conventional technology. The deposited doped polysilicon layers are polished off the front side of the wafers leaving a doped polysilicon layer on the backside of the wafer.

The depth of the oxygen denuded zone formed in the wafers after being subjected to simulated device temperature cycles is measured by lapping and polishing an edge of the wafer at a shallow angle of about 11°19' to provide a test surface approximately 1 cm. in length. The polished surface is then Wright etched. Under a 100X microscope the distance L from the top level of the prepared surface to the closest precipitate is measured. The denuded zone depth (DZ) is calculated as equal to $L \sin \phi + d$ where $\phi$ is the angle of bevel and d is the thickness of the top surface removed by the Wright etch.

MOS capacitors are prepared on the candidate wafers which have been cleaned by standard techniques. A 1,000 A° thick oxide surface layer on each wafer is formed by loading the wafers into a furnace at 800°C at 15.24 cm. per minute in an $N_2$ + 10% $O_2$ atmosphere, raising the temperature to 1,000°C. at 10° per minute, oxidizing in dry oxygen for 130 minutes, annealling in nitrogen for 30 minutes, reducing the temperature at 1°C. per minute to 600°C. in a nitrogen atmosphere, annealing in the presence of the forming gas for 30 minutes at 600°C. and removing from the furnace at 15.24 cm. per minute. Capacitors are formed by conventional aluminum evaporation and photolithographic techniques. MOS lifetimes are determined from capacitance measurements as a function of time after depleting the device with an electrical pulse using the well known method of M. Zerbest [Z. Agnew Physics, 22, 30(1966)].

EXAMPLE I

MOS capacitors are formed on a number of silicon wafers either having a polysilicon or a SIPOS layer on the backside prepared as described above under conditions set forth in Table 1 and standard wafers, as control. MOS generation lifetimes are determined as described above and the average of the results for like test wafers are reported in Table 1.

TABLE 1

| Wafer | DEPOSITION CONDITIONS | | | | | | |
|---|---|---|---|---|---|---|---|
| | SiH$_4$ (cc/min) | N$_2$O (cc/min) | Temp. (°C) | Pressure (mm of Hg) | Time (min) | Thickness Microns | Generation Lifetimes Milliseconds |
| A (Control) | - | - | | | | | 0.7 |
| B | 55 | - | 680 | 300 | 90 | 1.54 | 1.8 |
| C | 55 | 1.9 | 680 | 300 | 80 | 1.45 | 3.4 |
| D | 55 | 8.5 | 680 | 320 | 110 | 1.82 | 6.0 |

From the above data it is seen that generation lifetime increases as the thickness of the SIPOS layer and oxygen content increase and is more than double that obtained with only a polysilicon layer.

EXAMPLE II

Wafers having varying oxygen content SIPOS layers applied to the backside are prepared to demonstrate that the amount of oxygen in the SIPOS layer has an effect on, and can be used to control, wafer distortion known as bow. Bow is simply the deviation of the wafer from flatness in the unclamped state, without holding the wafer on a vacuum chunk. Bow is measured by supporting the wafer on 3 points near the edge of the back and measuring the position of the center of the front of the wafer. The wafer is then turned over and the change in elevation of the center of the wafer is noted. The value of the change divided by two is known as the bow of the wafer. If the polished side is concave, the wafer is known as dished and if it is convex the wafer is called a bowed wafer.

The SIPOS layers are applied to the silicon wafers using the reactor as described above. The temperatures along the reactor range from 624°C. at the door to 655°C. in the middle and 695°C. at the pump end. Sample wafers were placed at positions where the above temperatures were measured in order to obtain a variety of oxygen compositions, since the oxygen uptake of nitrous oxide versus the silane are different. A constant feed rate of 80 cc/min. of silane is provided. The difference in oxygen uptake occurs since the silane and nitrous oxide deplete at different rates. The actual layer compositions were determined analytically using an electron microprobe, by measuring the X-rays emitted when the sample was excited with an electron beam. The energy of the electron beam was kept low so that the electron penetration, throughout the analysis, was limited to the SIPOS deposited layer. The conditions used and the results of these procedures are given in Table II.

TABLE II

| WAFER | DEPOSITION CONDITIONS | | | | PROPERTIES | | |
|---|---|---|---|---|---|---|---|
| | TEMP (°C.) | N$_2$O (cc/min) | TIME (Min) | PRESSURE (mm of Hg) | O$_2$ IN SIPOS (wt %) | THICKNESS MICRONS | BOW Mils |
| A | 624 | 3.1 | 120 | 650 | 2.35 | 1.3 | 1.16 |
| B | 655 | 3.1 | 120 | 650 | 2.45 | 1.6 | 1.28 |
| C | 695 | 3.1 | 120 | 650 | 2.92 | 2.8 | 1.60* |
| D | 624 | 0 | 100 | 700 | 0 | 1.4 | 0.54 |
| E | 655 | 0 | 100 | 700 | 0 | 1.6 | 0.53 |
| F | 695 | 0 | 100 | 700 | 0 | 1.6 | 0.41 |

*Polished side of wafer convex bow, all others concave bow.

The results indicate the effect of oxygen content on inducing bow in the wafer as well as the quantity of oxygen on the type of bow. Thus, the oxygen content can be regulated to control bow of the wafer.

The above Examples used standard P⟨100⟩ type silicon wafers. However, polysilicon layers on any crystalline P or N type wafer provide improved gettering of deleterious defects, contaminants and impurities. Typical gettering improvements from polysilicon backside layers as indicated by generation lifetime will be at least about 4 times that of standard P⟨100⟩ type wafers and at least about 1.5 times that of standard P⟨111⟩ type wafers.

6

This invention, in addition to providing the electronics industry with an improved semiconductor substrate, permits control of semiconductor substrate characteristics such as denuded zone depth and oxygen precipitation through polysilicon backside layer thickness in relation to the specific requirements dictated by downstream needs and manufacturing conditions, such as particular device requirements and processing temperatures.

**Claims**

1. A method of manufacture of a semiconductor substrate, comprising a semiconductor material having a side for providing an active device region in an electronic device prepared from the substrate and having a layer of doped polysilicon on the backside of the substrate from such active device region, the layer providing the substrate with capability for gettering defects, contaminants and impurities, deleterious to the electronic device, to a region away from the active device region, the method comprising the steps of subjecting the semiconductor material to thermal processing conditions in the presence of oxygen to form an oxygen-doped polysilicon layer, by selecting a processing time (1) sufficient to gave the doped polysilicon layer a selected thickness in the range from 0.05 to 5.0 microns and (2) so that the oxygen is present in the layer in an amount in the range from 0.1 to 40.0 weight percent, the thickness and the oxygen percentage being selected so that the bow of the substrate reverses over the ranges, and carrying out the gettering of the semiconductor material.

2. A method according to claim 1, wherein the thickness of the layer is from 0.2 to 2.0 microns.

3. A method according to claim 2, wherein the thickness of the layer is from 0.6 to 1.0 microns.

4. A method according to any preceding claim wherein the oxygen is present in an amount in the range from 2 to 20 weight percent of the layer.

5. A method according to any preceding claim, wherein the semiconductor material is silicon.

6. A method according to any preceding claim, wherein the layer is applied to the semiconductor material by chemical vapour deposition of a silicon-containing material in the presence of oxygen.

7. A method according to claim 6, wherein the silicon-containing material is silane.

**Revendications**

1. Procédé de fabrication d'un substrat semiconducteur, comprenant une matière semiconductrice ayant un côté destiné à fournir une région de dispositif actif dans un dispositif électronique préparé à partir du substrat et ayant une couche de polysilicium dopé sur le côté arrière du substrat par rapport à cette région de dispositif actif, la couche conférant au substrat la possibilité de piéger des défauts, des contaminants et des impuretés, nuisibles au dispositif électronique, vers une région éloignée de la région de dispositif actif, le procédé comprenant les étapes qui consistent à soumettre la matière semiconductrice à des conditions de traitement thermique en présence d'oxygène pour former une couche de polysilicium dopé à l'oxygène en choisissant un temps de traitement (1) suffisant pour donner à la couche de polysilicium dopé une épaisseur choisie dans la plage de 0,05 à 5,0 micromètres et (2) tel que l'oxygène soit présent dans la couche en quantité comprise dans la plage de 0,1 à 40,0 % en poids, l'épaisseur et le pourcentage d'oxygène étant choisis de manière que la courbure du substrat s'inverse sur ces plages, et à effectuer le piégeage de la matière semiconductrice.

2. Procédé selon la revendication 1, dans lequel l'épaisseur de la couche est de 0,2 à 2,0 micromètres.

3. Procédé selon la revendication 2, dans lequel l'épaisseur de la couche est de 0,6 à 1,0 micromètre.

4. Procédé selon l'une quelconque des revendications précédentes, dans lequel l'oxygène est présent en quantité comprise dans la plage de 2 à 20 % en poids de la couche.

5. Procédé selon l'une quelconque des revendications précédentes, dans lequel la matière semiconductrice est du silicium.

6. Procédé selon l'une quelconque des revendications précédentes, dans lequel la couche est appliquée sur la matière semiconductrice par dépôt chimique en phase vapeur d'une matière contenant du silicium en présence d'oxygène.

7. Procédé selon la revendication 6, dans lequel la matière contenant du silicium est un silane.

**Patentansprüche**

1. Verfahren zum Herstellen eines Halbleitersubstrats mit einem Halbleitermaterial, das eine Seite zum Vorsehen eines aktiven Vorrichtungsbereiches in einer elektronischen Vorrichtung, die aus dem Substrat gebildet wird, hat, und an der von dem aktiven Vorrichtungsbereich gesehen Rückseite des Substrats eine Schicht aus dotiertem Polysilicium hat, wobei die Schicht dem Substrat die Eignung vermittelt, Defekte, Verunreinigungen und Unreinheiten, die für die elektronische Vorrichtung schädlich sind, in einem Bereich entfernt von dem aktiven Vorrichtungsbereich einzufangen, wobei das Verfahren die Schritte aufweist, Aussetzen des Halbleitermaterials thermischen Prozeßbedingungen bei Vorhandensein von Sauerstoff, so daß eine sauerstoffdotierte Polysiliciumschicht gebildet wird, wobei eine Prozeßzeit ausgewählt wird, (1) die ausreicht, daß die dotierte Polysiliciumschicht eine gewählte Dicke im Bereich von 0,05 bis 5,0 $\mu$m erhält, und (2) so daß der Sauerstoff in der Schicht mit einem Anteil im Bereich von 0,1 bis 40,0 Gew.-% vorliegt, die Dicke und der Sauerstoffprozentanteil so gewählt sind, daß der Bogen des Substrates über diesen Bereichen umgekehrt ist und das Einfangen des Halbleitermaterials durchführt.

2. Verfahren nach Anspruch 1, wobei die Dicke der Schicht von 0,2 bis 2,0 $\mu$m beträgt.

3. Verfahren nach Anspruch 2, wobei die Dicke der Schicht von 0,6 bis 1,0 $\mu$m beträgt.

4. Verfahren nach einem der vorstehenden Ansprüche, wobei der Sauerstoff mit einem Anteil in dem Bereich von 2 bis 20 Gew.-% der Schicht vorliegt.

5. Verfahren nach einem der vorstehenden Ansprüche, wobei das Halbleitermaterial Silicium ist.

6. Verfahren nach einem der vorstehenden Ansprüche, wobei die Schicht auf das Halbleitermaterial durch chemische Abscheidung aus der Dampfphase eines Silicium enthaltenden Materials bei Vorhandensein von Sauerstoff aufgebracht wird.

7. Verfahren nach Anspruch 6, wobei das Silicium enthaltende Material Silan ist.